# EUROPÄISCHE PATENTSCHRIFT

(11) **EP 3 253 902 B1**
(45) Veröffentlichungstag und Bekanntmachung des Hinweises auf die Patenterteilung: **05.10.2022**
(21) Anmeldenummer: 16702410.8
(22) Anmeldetag: 01.02.2016
(51) Int. Cl.: C23C 14/24, C23C 16/455

(54) **VORRICHTUNG ZUM BESCHICHTEN EINES GROSSFLÄCHIGEN SUBSTRATS**
DEVICE FOR COATING A SUBSTRATE HAVING A LARGE SURFACE AREA
DISPOSITIF POUR REVÊTIR UN SUBSTRAT DE SURFACE IMPORTANTE

(30) Priorität: 02.02.2015 DE 102015101461
(43) Veröffentlichungstag der Anmeldung: 13.12.2017
(73) Patentinhaber: Aixtron SE, 52134 Herzogenrath (DE)
(72) Erfinder: GOPI, Baskar Pagadala, 52072 Aachen (DE); ABDEL-KARIM, Roger, 52134 Herzogenrath (DE); BACKES, Patrick Marie Antonius, 6101GL Echt (NL)
(74) Vertreter: Grundmann, Dirk
(86) Internationale Anmeldenummer: PCT/EP2016/052021
(87) Internationale Veröffentlichungsnummer: WO 2016/124517

(56) Entgegenhaltungen:
- JP-A- 2012 216 744
- US-A1- 2009 133 631
- US-A1- 2012 027 918
- US-A1- 2014 145 160
- US-B1- 6 286 454

## Beschreibung

Die Erfindung betrifft eine Vorrichtung zum Beschichten eines Substrats mit einem Gaseinlassorgan, das eine Gasverteilkammer mit einer Gasaustrittsfläche aufweist mit im Wesentlichen gleichmäßig über die Gasaustrittsfläche verteilt angeordneten Gasaustrittsöffnungen, durch die ein in die Gasverteilkammer eingespeistes Prozessgas in eine Prozesskammer und zu dem auf den Boden der Prozesskammer angeordneten Substrat gelangen kann, wobei die Gasaustrittsfläche von mehreren in einer gemeinsamen Ebene liegenden Gasaustrittsplatten gebildet ist, die im Bereich von entfernt von das Volumen der Gasverteilkammer begrenzenden Seitenwänden angeordneten Trennzonen aneinander angrenzen.

Die JP 2013-187318 A beschreibt ein Gaseinlassorgan in einem CVD-Reaktor, bei dem das Gaseinlassorgan neun Bodenplatten besitzt, die jeweils Elektroden ausbilden.

Die US 2011/0180213 A1 beschreibt an einer Unterseite einer Decke einer Prozesskammer angeordnete metallische Elektroden, zwischen denen elektrische Platten angeordnet sind. In den Elektroden sind Gasdurchtrittsöffnungen angeordnet.

Die US 2010/0167551 A1 beschreibt ein Gaseinlassorgan in Form eines Showerheads mit einer Gasaustrittsfläche.

CVD-Beschichtungsanlagen sind darüber hinaus bekannt aus der DE 10 2013 101 534 A1 bzw. einer nicht vorveröffentlichten DE 10 2014 116 991.

Die US 8,721,791 B2 und die US 2009/0133631 A1 beschreiben Einlassorgane mit einer Gasaustrittsfläche, die Gasaustrittsöffnungen aufweisen und die mittels Halteorganen nach oben befestigt sind.

In US2014/0145160 A1 wird ein organischer Ausgangsstoff in ein beheiztes Gaseinlassorgan mit Hilfe von Trägergas eingespeist.

Eine erfindungsgemäße Beschichtungseinrichtung besitzt einen Suszeptor zur Aufnahme des zu beschichteten Substrats und ein die Funktion eines Gasverteilers ausübendes Gaseinlassorgan, mit dem Prozessgase in die Prozesskammer eingeleitet werden können. Die Prozesskammer befindet sich unterhalb des Gasverteilers und oberhalb des Suszeptors. Durch die sich an der Unterseite der Gasaustrittsfläche des Gaseinlassorgans angeordneten Gasaustrittsöffnungen treten die Prozessgase in die Prozesskammer ein. Innerhalb des Gaseinlassorganes befindet sich mindesten eine Kammer zur Verteilung des Prozessgases an die Gasaustrittsöffnungen. Es können aber auch mehrere Gasverteilkammern in dem Gaseinlassorgan angeordnet sein, die jeweils mit ihren individuell zugeordneten Gasaustrittsöffnungen strömungsverbunden sind.

Zur Abscheidung von OLEDs werden organische Ausgangsstoffe mit Hilfe eines Trägergases in einen beheizten Gasverteiler eingespeist. Zumindest die Gasaustrittsfläche ist beheizt. Durch die Gasaustrittsöffnungen, deren Temperatur oberhalb der Kondensationstemperatur des Prozessgases liegt, treten ein Trägergas und ein das Trägergas transportierender Prekursor in die Prozesskammer, ein. Der gasförmige Prekursor kondensiert auf dem Substrat. Dieses wird hierzu von einem gekühlten Suszeptor getragen. Die Substrate können eine Oberfläche von mehr als einem Quadratmeter besitzen. Daraus ergibt sich die Anforderung, eine Beschichtungsvorrichtung mit einer Suszeptordiagonalen von zwei bis drei Metern herzustellen. Das Gaseinlassorgan soll sich über die gesamte Fläche des Suszeptors erstrecken. Das Gaseinlassorgan muss somit eine Diagonale von zwei bis drei Meter besitzen. Die Prozesskammer besitzt hingegen eine Prozesskammerhöhe von nur wenigen Zentimetern.

Der Erfindung liegt die Aufgabe zu Grunde, eine gattungsgemäße Vorrichtung dahingehend weiterzubilden, dass innerhalb der Prozesskammer großflächige Substrate abgeschieden werden können.

Gelöst wird die Aufgabe durch die in den Ansprüchen angegebene Erfindung.

Zunächst und im Wesentlichen wird vorgeschlagen, dass die Gasaustrittsfläche von einer zusammenhängenden Gasverteilkammer von mehreren Gasaustrittsplatten gebildet ist. Die Gasaustrittsplatten liegen in einer gemeinsamen Ebene. Gasaustrittsplatten grenzen in Trennzonen aneinander. Die Trennzonen können Trennlinien sein. Benachbarte Gasaustrittsplatten können in den Trennzonen unmittelbar aneinander angrenzen. Sie können aber auch mittelbar aneinander angrenzen, beispielsweise, wenn zwischen zwei benachbarten Gasaustrittsplatten ein Steg eines gitterartigen Tragrahmens oder dergleichen verläuft. Das Volumen der Gasverteilkammer wird durch Seitenwände begrenzt. Die Trennzonen verlaufen entfernt von den Seitenwänden der Gasverteilkammer. Die Trennzonen können gradlinig verlaufen und somit die Gasverteilkammer kreuzen. Grenzen zwei Gasaustrittsplatten unmittelbar aneinander, so bilden sich Trennlinien aus, die die Gasverteilkammer kreuzen. Die aus einzelnen Gasaustrittsplatten bestehende Gasaustrittsfläche kann somit fertigungstechnisch einfacher hergestellt werden. Es ist ferner von Vorteil, wenn die aneinander angrenzenden Gasaustrittsplatten sich im Bereich der Trennzonen geringfügig gegeneinander bewegen können. Es ist vorgesehen, dass sich benachbarte Gasaustrittsplatten entlang der Trennzone bzw. Trennlinien scharnierartig gegeneinander bewegen können. Mit geeigneten Justierelementen kann dadurch die Höhenlage jeder Gasaustrittsplatte gegenüber dem Boden der Prozesskammer verstellt werden.

In Kombination mit den zuvor bezeichneten technischen Merkmalen kann eine erfindungsgemäße Vorrichtung auch dadurch weitergebildet sein, dass sich zwei benachbarte Gasaustrittsplatten im Bereich der Trennzone überlappen. Hierzu können die Gasaustrittsplatten querschnittsverminderte Fortsätze besitzen. Die querschnittsverminderten Fortsätze greifen derart übereinander, dass sowohl die zur Prozesskammer weisenden Breitseitenflächen benachbarter Gasaustrittsplatten als auch zur Gasverteilkammer weisenden Breitseitenflächen benachbarter Gasaustrittsplatten bündig ineinander übergehen. Die Befestigung zweier nebeneinander angeordneter Gasaustrittsplatten kann über eine Verschraubung erfolgen, wobei Verbindungsschrauben durch die sich überlappenden Bereiche der Gasaustrittsplatte geschraubt sind. Anstelle einer unmittelbaren Überlappung zweier benachbarter Gasaustrittsplatten kann auch ein Verbindungsstreifen vorgesehen sein. Dieser Verbindungsstreifen besitzt bevorzugt etwa die halbe Materialstärke wie die Gasaustrittsplatte und liegt jeweils bündig in einer von zwei querschnittsverminderten Vorsprüngen gebildeten Aussparung ein, wobei die Aussparung bevorzugt in Richtung der Gasverteilkammer weist. Jede einzelne Gasaustrittsplatte ist mit mindestens einem Hänger nach oben befestigt. Der Hänger kann an der Rückwand des Gaseinlassorganes, an einer Decke des Gehäuses oder an einem Tragfachwerk befestigt sein, welches wiederrum an der Decke des Gehäuses befestigt ist. Zumindest einige der Gasaustrittsplatten sind mit mindestens drei Hängern befestigt. Jede Gasaustrittsplatte besitzt eine Vielzahl im Wesentlichen gleichmäßig über ihre Flächenerstreckung angeordnete Gasaustrittsöffnungen, sodass insgesamt eine Gasaustrittsfläche in Form eines Showerheads entsteht. Es kann eine Heizeinrichtung vorgesehen sein, mit der die Gasaustrittsplatte beheizbar ist. Jede Gasaustrittsplatte kann eine ihr individuell zugeordnete Heizeinrichtung aufweisen. Bei der Heizeinrichtung kann es sich um einen durch Hindurchleiten eines Stroms aufheizbaren Draht handeln. Dieser kann in einer Rinne der zur Gasverteilkammer weisenden Breitseitenfläche der Gasaustrittplatte einliegen. Erfindungsgemäß sind Justierelemente vorgesehen, mit denen die Höhenlage jeder einzelnen Gasaustrittsplatte gegenüber dem Substrat einstellbar ist. Diese Justierelemente sind bevorzugt rückwärtig der Gasaustrittsfläche angeordnet. Sie können am rückwärtigen oberen Ende des Hängers vorgesehen sein. Bei den Justierelementen kann es sich um Gewindeelemente handeln, bspw. um eine mit einem Gewindeschaft zusammenwirkende Mutter. Der Suszeptor ist mit einer Kühleinrichtung versehen. Diese kann von Kühlkanälen gebildet sein, die innerhalb des Suszeptors angeordnet sind. Ein Gasauslassorgan zum Austritt des Prozessgases bzw. Trägergases aus dem Gehäuse kann mit einer Vakuumpumpe verbunden sein, sodass das Gehäuse evakuierbar ist. Die Hänger sind bevorzugt so angeordnet, dass sie nicht in einem direkten Kontakt mit dem gasförmigen Prekursor kommen können. Es ist ferner vorgesehen, dass die Höhenlage der Gasaustrittsplatten und deren vertikale Lage individuell einstellbar sind. Die zur Ausbildung einer zusammenhängenden Gasaustrittsfläche verwendeten Gasaustrittsplatten können untereinander verschiedene Größen aufweisen. Die Gasaustrittsplatten haben bevorzugt eine rechteckige Gestalt und besitzen Ränder, die so ausgebildet sind, dass zwei nebeneinander angeordnete Gasaustrittsplatten durch einen Überlapp miteinander verbunden werden können. Die Überlappzone, die identisch ist mit der Trennzone, besitzt eine Breite, die geringer ist, als der Abstand zweier auf einer Gasaustrittsplatte unmittelbar benachbart angeordneter Gasaustrittsöffnungen. Es könnten mechanische, insbesondere elektromechanische Justierelemente vorgesehen sein, mit denen durch Angriff an den Hängern die Höhe der Gasaustrittsplatten über dem Suszeptor justiert werden können. In einer Variante der Erfindung sind zweite Hänger vorgesehen, mit denen die Rückseite des Gaseinlassorgans entweder an der Decke des Gehäuses oder an einem an der Decke des Gehäuses befestigten Tragfachwerks aufgehangen werden kann.

Ausführungsbeispiele der Erfindung werden nachfolgend anhand beigefügter Zeichnungen erläutert, wobei die Zeichnungen lediglich großschematisch Elemente einer Beschichtungsanlage wiedergeben. Es zeigen:
- Figur 1:: Den Querschnitt durch eine Beschichtungsvorrichtung eines ersten Ausführungsbeispiels der Erfindung, bei dem drei Austrittsplatten 10, 11, 12 eine einer einzigen Gasverteilkammer 5 zugeordneten Gasaustrittsfläche 2' bilden,
- Figur 2:: in einer perspektivischen Darstellung ein Ensemble aus zehn unterschiedlich großen Gasaustrittsplatten 10-19, die eine einheitliche Gasaustrittsfläche ausbilden,
- Figur 3:: einen Schnitt gemäß Linie III-III in Figur 2,
- Figur 4:: ein weiteres Ausführungsbeispiel in einer Darstellung gemäß Figur 3,
- Figur 5:: ein weiteres Ausführungsbeispiel in einer Darstellung gemäß Figur 1,
- Figur 6:: eine Darstellung gemäß Figur 5 eines weiteren Ausführungsbeispiels.

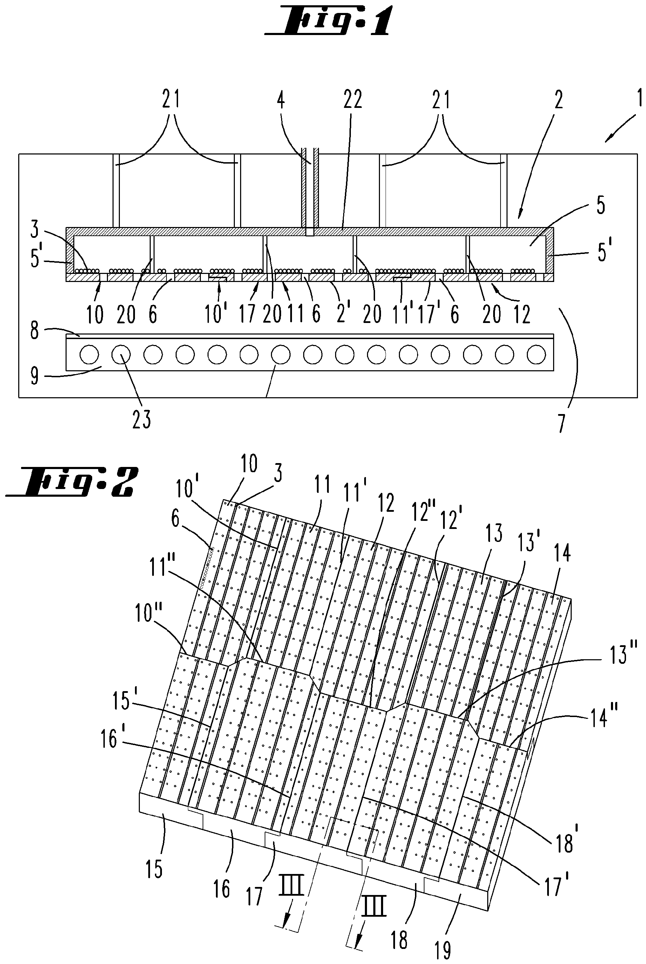

Die Figur 1 zeigt grobschematisch ein lediglich angedeutetes Gehäuse 1 einer Beschichtungsvorrichtung zum Abscheiden von OLEDs. Innerhalb des Gehäuses 1 befindet sich ein Gaseinlassorgan 2, bei dem es sich um ein flaches, hohles Gehäuse handelt, welches eine Rückwand 22 aufweist, an der mittels Hänger 20 insgesamt drei Gasaustrittsplatten 10, 11, 12 befestigt sind.

Unterhalb der drei Gasaustrittsplatten 10, 11, 12, die eine Gasaustrittsfläche 2' ausbilden, befindet sich eine wenige Zentimeter hohe Prozesskammer 7. Den Boden der Prozesskammer 7 bildet eine nach oben weisende Oberfläche eines Suszeptors 9, die ein zu beschichtendes Substrat 8 von mindestens einem Quadratmeter trägt. Die Diagonale des bevorzugt rechteckigen Suszeptors 9 beträgt etwa zwei bis drei Meter. Innerhalb des Suszeptors 9 befinden sich Kühlkanäle 23 zum Hindurchleiten einer Kühlflüssigkeit.

Die Gasaustrittsfläche 2' erstreckt sich über die gesamte Oberfläche des Suszeptors 9. Sie besitzt somit eine Diagonale von zwei bis drei Metern.

Das kastenförmige Gaseinlassorgan 2 bildet Seitenwände 5' aus. Die Seitenwände 5' umgeben eine einheitliche Gasverteilkammer 9, die von einer Zuleitung 4 von außen her mit einem Trägergas und einem davon geförderten gasförmigen Prekursor gespeist wird.

Mittels Hängern 21 ist das Gaseinlassorgan 2 an der Unterseite einer Decke des Gehäuses 1 befestigt. Hierzu sind die Hänger mit ihrem einen Ende an der Decke des Gehäuses 1 und mit ihrem anderen Ende an der Rückwand 22 des Gaseinlassorganes befestigt. An der Rückwand 21 sind Hänger 20 befestigt, die sich von der Rückwand 22 bis zu den Gasaustrittsplatten 10, 11, 12 erstrecken. Jede Gasaustrittsplatte 10, 11, 12 ist somit mit mindestens einem Hänger 20 an der Rückwand 22 befestigt.

Zwei benachbarte Gasaustrittsplatten 10, 11, 12 grenzen an Trennzonen 10', 11' aneinander. Die Trennzonen verlaufen frei unterhalb der Gasverteilkammer 5 entfernt von Seitenwänden 5' und den Trennzonen sind somit örtlich keine Wände oder dergleichen zugeordnet. Beim Ausführungsbeispiel bildet sich in der jeweiligen Trennzone 10', 11' eine linienförmige, im Querschnitt z-förmig verlaufende Stoßkante, an der zwei benachbarte Gasaustrittsplatten 10, 11, 12 aneinander stoßen. Im Bereich der Trennzone 10', 11' überlappen zwei dort aneinander stoßende Gasaustrittsplatten 10, 11, 12.

Jede Gasaustrittsplatte 10, 11, 12 besitzt eine Vielzahl von Gasaustrittsöffnungen 6. Die Bezugsziffer 3 deutet eine Heizeinrichtung an, mit der die Gasaustrittsplatten 10, 11, 12 beheizt werden können. Mittels der Heizeinrichtungen 3 werden die Gasaustrittsplatten 10, 11, 12 auf eine Temperatur geheizt, die oberhalb der Kondensationstemperatur des organischen Ausgangsstoffs liegt, der durch die Zuleitung 4 in die Gasverteilkammer 5 eingespeist wird und der die Gasverteilkammer 5 durch die Gasaustrittsöffnungen 6 verlässt, um in die Prozesskammer 7 eingespeist zu werden. Dort gelangt der organische Ausgangsstoff als Dampf auf die Oberseite des Substrates 8, wo der Dampf unter Ausbildung einer Schicht kondensiert.

Das in der Figur 2 dargestellte Ausführungsbeispiel zeigt eine Gasaustrittsfläche, die von insgesamt zehn Gasaustrittsplatten 10, 11, 12, 13, 14, 15, 16, 17, 18, 19 gebildet ist. Die einzelnen Gasaustrittsplatten 10-19 haben eine rechteckige Form. Sie liegen zeilenartig sowohl hintereinander als auch nebeneinander. Sie besitzen eine unterschiedliche Größe. Die Gasaustrittsplatten 10-19 sind in Form einer zweidimensionalen Matrix innerhalb einer Fläche angeordnet.

Zwei benachbarte Gasaustrittsplatten 10 bis 19 stoßen an linienförmig verlaufenden Trennzonen 10', 10", 11', 11", 12', 12", 13', 13", 14", 15', 16', 17' und 18' aneinander. Einige der Gasaustrittsplatten, nämlich die Gasaustrittsplatten 11, 12, 13, 15, 16, 17 besitzen insgesamt drei rechtwinklig zueinander stehende Randkanten, die an Randkanten benachbarter Gasaustrittsplatten anstoßen. Benachbarte Gasaustrittsplatten 10-19 stoßen unter Ausbildung eines Überlappungsbereiches aneinander, wobei die Überlappungszonen so ausgebildet sind, dass die Breitseiten zweier benachbarter Gasaustrittsplatten bündig ineinander übergehen.

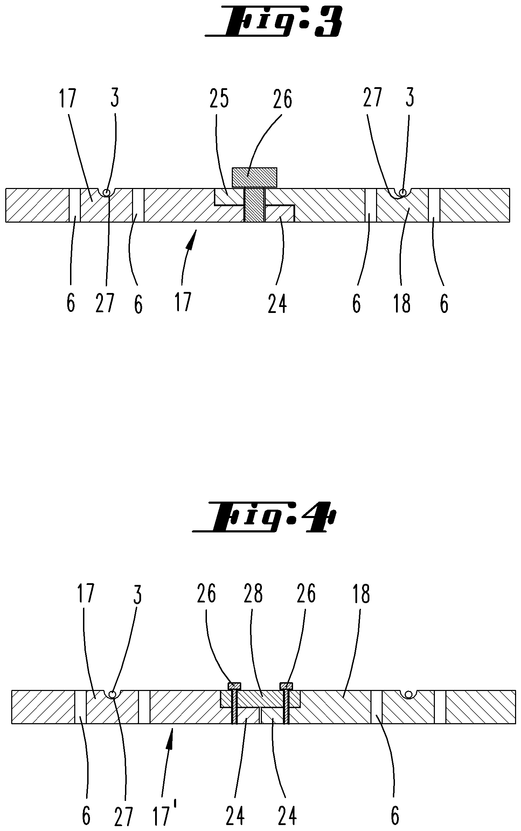

Die Figur 3 zeigt in einer vergrößerten Darstellung die Trennzone 17' zwischen den beiden Gasaustrittsplatten 17 und 18. Die Gasaustrittsplatte 17 bildet einen querschnittsverminderten Randbereich aus, sodass sich ein Vorsprung 24 und ein darüber liegender Freiraum ergibt. Die Randkante der Gasaustrittsplatte 18 ist derart querschnittsvermindert, dass sich dort ein Vorsprung 25 mit einem darunterliegenden Freiraum ausbildet. Die beiden Vorsprünge 24, 25 können in eine derartige Überlappung gebracht werden, dass eine Schraube 26 durch eine Bohrung des Fortsatzes 25 hindurchgesteckt und in ein Innengewinde des Fortsatzes 24 eingeschraubt werden kann, sodass zwei benachbarte Gasaustrittsplatten 17,18 miteinander verbunden werden können.

Die Figur 3 zeigt darüber hinaus auch einen in einer Rinne 27 liegenden Heizdraht 3, mit dem die Gasaustrittsplatte 17,18 beheizt werden kann. Jeder der beiden Gasaustrittsplatten 17,18 kann individuell ein Heizdraht 3 zugeordnet sein, sodass die Gasaustrittsplatten 17,18 individuell beheizbar sind.

Die Figur 4 zeigt eine Alternative zur Figur 3. Auch hier bilden die Ränder zweier benachbarter Gasaustrittsplatten 17, 18 jeweils Fortsätze 24 aus. Die beiden Fortsätze 24 formen hier aber eine nach oben, also zur Gasverteilkammer 5 hin offene Nut. In dieser offenen Nut liegt ein Verbindungsstreifen 28 ein. Der Verbindungsstreifen hat etwa die Hälfte der Materialstärke der Gasaustrittsplatte 17,18. Die Verbindung des Verbindungsstreifens 28 mit den Vorsprüngen 24 erfolgt auch hier mittels einer Schraube 26.

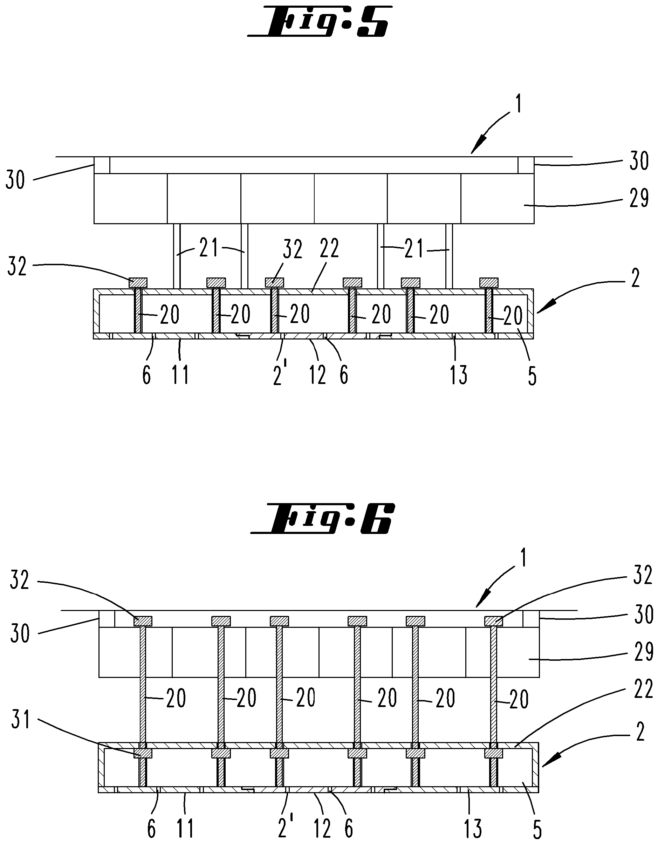

Bei dem in der Figur 5 dargestellten Ausführungsbeispiel sind Justierelemente 32 dargestellt, mit denen die effektive Länge der Hänger 20 eingestellt werden kann. Die Justierelemente 32 befinden sich hier an der Rückseite des Gaseinlassorgans 2. Es kann sich um Muttern handeln, die auf Gewindeschäften aufgeschraubt sind, sodass sich durch Drehen der Mutter die effektive Länge des Hängers 20 einstellen lässt, dessen Ende an einer Gasaustrittsplatte 11, 12, 13 befestigt ist.

Mittels Hängern 21 ist das gesamte Gaseinlassorgan 2 an einem thermisch stabilisierten Tragfachwerk 29 befestigt. Das Tragfachwerk 29 besitzt eine ausreichende Steifigkeit, sodass es weder durch eine Evakuierung des Gehäuses 1, noch durch eine Aufheizung in nennenswerter Weise verformt wird. Das Tragfachwerk 29 ist mittels Befestigungselementen 30 an der Decke des Gehäuse 1 befestigt.

Das in der Figur 6 dargestellte Ausführungsbeispiel entspricht im Wesentlichen dem in der Figur 5 dargestellten Ausführungsbeispiel. Auch hier greifen an der zur Gasverteilkammer 5 weisenden Seite der drei Gasaustrittsplatten 11, 12, 13 Hänger 20 an. Die Hänger 20 sind am Tragfachwerk 29 befestigt. Dort befinden sich auch Justierelemente 32, um die effektive Länge der Hänger 20 einzustellen und damit die vertikale Position der Gasaustrittsplatten 11, 12, 13 gegenüber dem Suszeptor. Es sind Stützelemente 31 vorgesehen, die fest mit dem Hänger 20 verbunden sind und die die Rückwand 22 des Gaseinlassorgans 2 unterstützen. Bei den Ausführungsbeispielen bestehen die Gasaustrittsplatten 10-19 aus Metall. Die Metalloberflächen können beschichtet sein. Die Ausführungsbeispiele zeigen ein Gaseinlassorgan, welches lediglich eine Gasverteilkammer aufweist. Nicht dargestellte Ausführungsbeispiele besitzen ein Gaseinlassorgan, welches mehrere Gasverteilkammern aufweist, sodass getrennt voneinander verschiedene Prozessgasse in die Prozesskammer eingeleitet werden können.

**Bezugszeichenliste:**

| | | | |
|---|---|---|---|
| 1 | Gehäuse | 15 | Gasaustrittsplatte |
| 2 | Gaseinlassorgan | 15' | Trennzone |
| 2' | Gasaustrittsfläche | 16 | Gasaustrittsplatte |
| 3 | Heizelement | 16' | Trennzone |
| 4 | Gaszuleitung | 17 | Gasaustrittsplatte |
| 5 | Gasverteilkammer | 17' | Trennzone |
| 5' | Seitenwand | 18 | Gasaustrittsplatte |
| 6 | Gasaustrittsöffnung | 18' | Trennzone |
| 7 | Prozesskammer | 19 | Gasaustrittsplatte |
| 8 | Substrat | 20 | Hänger |
| 9 | Suszeptor | 21 | Hänger |
| 10 | Gasaustrittsplatte | 22 | Rückwand |
| 10' | Trennzone | 23 | Kühlkanäle |
| 10" | Trennzone | 24 | Fortsatz |
| 11 | Gasaustrittsplatte | 25 | Fortsatz |
| 11' | Trennzone | 26 | Schraube |
| 11" | Trennzone | 27 | Rinne |
| 12 | Gasaustrittsplatte | 28 | Verbindungsstreifen |
| 12' | Trennzone | 29 | Tragfachwerk |
| 12" | Trennzone | 30 | Befestigungselement |
| 13 | Gasaustrittsplatte | 31 | Stützelemente |
| 13' | Trennzone | 32 | Justierelement |
| 13" | Trennzone | | |
| 14 | Gasaustrittsplatte | | |
| 14' | Gasaustrittsplatte | | |
| 14" | Trennzone | | |

## Patentansprüche

1. Vorrichtung zum Beschichten eines Substrats (8) mit einem Gaseinlassorgan (2), das eine Gasverteilkammer (5) mit einer Gasaustrittsfläche aufweist mit im Wesentlichen gleichmäßig über die Gasaustrittsfläche (2') verteilt angeordneten Gasaustrittsöffnungen (6), durch die ein in die Gasverteilkammer (5) eingespeistes Prozessgas in eine Prozesskammer (7) und zu dem auf den Boden der Prozesskammer angeordneten Substrat (8) gelangen kann, wobei die Gasaustrittsfläche von mehreren in einer gemeinsamen Ebene liegenden Gasaustrittsplatten (10, 11, 12, 13, 14, 15, 16, 17, 18, 19) gebildet ist, die im Bereich von entfernt von das Volumen der Gasverteilkammer (5) begrenzenden Seitenwänden (5') angeordneten Trennzonen (10', 10", 11', 11", 12', 12", 13', 13", 14", 15', 16', 17', 18') aneinander angrenzen, **dadurch gekennzeichnet, dass** sich zwei benachbarte Gasaustrittsplatten (10 - 19) entlang ihrer gemeinsamen Trennzone (10', 10", 11', 11", 12', 12", 13', 13", 14", 15', 16', 17', 18') scharnierartig gegeneinander verlagern lassen und jede einzelne Gasaustrittsplatte (10-19) mit mindestens einem Hänger (20) an einer Rückwand (22) des Gaseinlassorganes (2), an einer Decke des Gehäuses (1) oder an einem Tragfachwerk (29) befestigt ist, wobei die Hänger (20) Justierelemente (32) aufweisen, um die vertikale Lage der Gasaustrittsplatte (11-19) gegenüber dem Boden der Prozesskammer zu verstellen.

2. Vorrichtung nach Anspruch 1, **dadurch gekennzeichnet, dass** sich zwei benachbarte Gasaustrittsplatten (10-19) im Bereich der Trennzonen (10', 10", 11', 11", 12', 12", 13', 13", 14", 15', 16', 17', 18') überlappen oder von einem Verbindungsstreifen (28) überlappt werden.

3. Vorrichtung nach einem der vorhergehenden Ansprüche, **dadurch gekennzeichnet, dass** zur Aufhängung einer Gasaustrittsplatte (10-19) mindestens drei Hänger verwendet werden.

4. Vorrichtung nach einem der vorhergehenden Ansprüche, **gekennzeichnet durch** eine Heizeinrichtung (3), um die Gasaustrittsplatten (10-19) zu temperieren.

5. Vorrichtung nach einem der vorhergehenden Ansprüche, **dadurch gekennzeichnet, dass** die Justierelemente rückseitig des Gaseinlassorganes angeordnet sind.

6. Vorrichtung nach einem der vorhergehenden Ansprüche, **dadurch gekennzeichnet, dass** die Gasaustrittsplatten (10-19) im Bereich der Trennzone querschnittsverminderte Fortsätze (24, 25) aufweisen, die sich entweder überlappen oder von einem Streifen (28) überlappt werden, sodass die Breitseitenflächen zweier an einer Trennzone (10', 10", 11', 11", 12', 12", 13', 13", 14", 15', 16', 17', 18') aneinander stoßende Gasaustrittsplatten (11-19) bündig ineinander übergehen.

7. Vorrichtung nach einem der vorhergehenden Ansprüche, **dadurch gekennzeichnet, dass** jeder Gasaustrittsplatte (11, 19) ein individuell beheizbares Heizelement (3) zugeordnet ist.

8. Vorrichtung nach einem der vorhergehenden Ansprüche, **dadurch gekennzeichnet, dass** die Gasaustrittsfläche von Gasaustrittsplatten (10-19) von einander verschiedener Größe ausgebildet ist.

## Claims

1. Device for coating a substrate (8) with a gas inlet member (2), which has a gas distribution chamber (5) with a gas outlet surface with gas outlet openings (6) arranged substantially uniformly over the gas outlet surface (2'), through which a process gas fed into the gas distribution chamber (5) can pass into a process chamber (7) and to the substrate (8) arranged on the bottom of the process chamber, wherein the gas outlet surface is formed by a plurality of gas outlet plates (10, 11, 12, 13, 14, 15, 16, 17, 18, 19) lying in a common plane, which are arranged in the region of separation zones (10', 10", 11', 11", 12', 12", 13', 13", 14", 15', 16', 17', 18') adjoining one another being located in a distance to walls (5') limiting the volume of the gas distribution chamber (5), **characterized in that** two adjacent gas outlet plates (10 - 19) extend along their common separation zone (10', 10", 11", 12', 12", 13", 14", 15', 16', 17', 18') can be displaced in a hinge-like manner with respect to one another and each individual gas outlet plate (10-19) is fastened by means of at least one hanger (20) to a rear wall (22) of the gas inlet member (2), to a ceiling of the housing (1) or to a supporting framework (29), the hangers (20) having adjusting elements (32) in order to adjust the vertical position of the gas outlet plate (11-19) with respect to the base of the process chamber.

2. Device according to claim 1, **characterized in that** two adjacent gas outlet plates (10-19) overlap in the region of the separation zones (10', 10", 11', 11", 12', 12", 13', 13", 14", 15', 16', 17', 18') or are overlapped by a connecting strip (28).

3. Device according to one of the preceding claims, **characterized in that** at least three hangers are used to suspend a gas outlet plate (10-19).

4. Device according to one of the preceding claims, **characterized by** heating means (3) for tempering the gas outlet plates (10-19).

5. Device according to one of the preceding claims, **characterized in that** the adjustment elements are arranged at the rear of the gas inlet member.

6. Device according to one of the preceding claims, **characterized in that** the gas outlet plates (10-19) have, in the region of the separation zone, crosssectionally reduced extensions (24, 25) which either overlap or are overlapped by a strip (28), so that the broadside surfaces of two gas outlet plates (11-19) abutting one another at a separation zone (10', 10", 11", 12', 12", 13', 13", 14", 15', 16', 17', 18') merge flush with one another.

7. Device according to one of the preceding claims, **characterized in that** an individually heatable heating element (3) is associated with each gas outlet plate (11, 19).

8. Device according to one of the preceding claims, **characterized in that** the gas outlet area is formed by gas outlet plates (10-19) of mutually different sizes.

## Revendications

1. Dispositif pour revêtir un substrat (8) avec un organe d'entrée de gaz (2), qui comporte une chambre de répartition de gaz (5) avec une surface de sortie de gaz, avec des ouvertures de sortie de gaz (6) disposées pour l'essentiel réparties régulièrement sur la surface de sortie de gaz (2'), à travers lesquelles un gaz de traitement acheminé dans la chambre de répartition de gaz (5) peut parvenir dans une chambre de traitement (7) et au substrat (8) disposé sur le fond de la chambre de traitement, sachant que la surface de sortie de gaz est formée de plusieurs plaques de sortie de gaz (10, 11, 12, 13, 14, 15, 16, 17, 18, 19) situées dans un plan commun, qui se touchent l'une contre l'autre dans le secteur des zones de séparation (10', 10", 11', 11", 12', 12", 13', 13", 14", 15', 16', 17', 18') disposées dans le secteur des parois latérales (5') limitrophes, éloignées du volume de la chambre de répartition de gaz (5), **caractérisé en ce que** deux plaques de sortie de gaz voisines (10-19) peuvent être déplacées l'une contre l'autre à la façon d'une charnière le long de leur zone de séparation commune (10', 10", 11', 11", 12', 12", 13', 13", 14", 15', 16', 17', 18') et chaque plaque de sortie de gaz individuelle (10-19) est fixée avec au moins une suspension (20) à une paroi arrière (22) de l'organe d'entrée de gaz (2), à un plafond de l'enceinte (1) ou à une charpente porteuse (29) , sachant que les suspensions (20) comportent des éléments d'ajustage (32) pour régler la position verticale de la plaque de sortie de gaz (11-19) par rapport au fond de la chambre de traitement.

2. Dispositif selon la revendication 1, **caractérisé en ce que** deux plaques de sortie de gaz voisines (10-19) se chevauchent dans le secteur des zones de séparation (10', 10", 11', 11", 12', 12", 13', 13", 14", 15', 16', 17', 18') ou sont recouvertes par une bande de liaison (28).

3. Dispositif selon l'une quelconque des revendications précédentes, **caractérisé en ce qu'**au moins trois suspensions sont utilisées pour suspendre d'une plaque de sortie de gaz (10-19).

4. Dispositif selon l'une quelconque des revendications précédentes, **caractérisé par** un système de chauffage (3), pour tempérer les plaques de sortie de gaz (10-19).

5. Dispositif selon l'une quelconque des revendications précédentes, **caractérisé en ce que** les éléments d'ajustage sont disposés à l'arrière de l'organe d'entrée de gaz.

6. Dispositif selon l'une quelconque des revendications précédentes, **caractérisé en ce que** les plaques de sortie de gaz (10-19) comportent dans le secteur de la zone de séparation des prolongements de section réduite (24, 25), qui soit, se chevauchent, soit sont recouverts par une bande (28) de telle manière que les surfaces latérales larges de deux plaques de sortie de gaz (11-19) bout à bout l'une contre l'autre à une zone de séparation (10', 10", 11', 11", 12', 12", 13', 13", 14", 15', 16', 17', 18') se fondent l'une dans l'autre par affleurement.

7. Dispositif selon l'une quelconque des revendications précédentes, **caractérisé en ce qu'**un élément chauffant pouvant être chauffé (3) est attribué à chaque plaque de sortie de gaz (11, 19).

8. Dispositif selon l'une quelconque des revendications précédentes, **caractérisé en ce que** la surface de sortie de gaz est constituée de plaques de sortie de gaz (10-19) d'une taille différente l'une de l'autre.
